(19)

Europäisches
Patentamt

European
Patent Office

Office européen
des brevets

(11) **EP 4 772 845 A2**

(12) **EUROPEAN PATENT APPLICATION**

(43) Date of publication:
**08.07.2026  Bulletin 2026/28**

(21) Application number: **25222240.1**

(22) Date of filing: **10.12.2025**

(51) International Patent Classification (IPC):
**G01J 1/02** *(2006.01)*      **G01J 1/04** *(2006.01)*
**G01J 1/42** *(2006.01)*      **G02B 3/00** *(2006.01)*

(52) Cooperative Patent Classification (CPC):
**G01J 1/4204; G01J 1/0266; G01J 1/0411;**
**G01J 1/0437; G02B 3/0037;** G01J 1/0488

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **12.12.2024  CN 202411833222**

(71) Applicant: **Goodix Technology (Chengdu) Co.,
Ltd.**
**Chengdu, Sichuan 610095 (CN)**

(72) Inventors:
• **ZHANG, Sichao**
  **Chengdu, Sichuan, 610095 (CN)**
• **WEI, Ya**
  **Chengdu, Sichuan, 610095 (CN)**

(74) Representative: **Kraus & Lederer PartGmbB**
**Thomas-Wimmer-Ring 15**
**80539 München (DE)**

(54) **LIGHT SENSOR AND ELECTRONIC DEVICE**

(57)    A light sensor and an electronic device are provided. The light sensor includes: at least one light gathering unit, at least one light blocking unit, and a light sensing unit. In a direction perpendicular to a light sensing plane of the light sensing unit, each light gathering unit corresponds to at least one light blocking unit, and the light blocking unit is located between the light gathering unit and the light sensing plane, the light blocking unit blocks, after first incident light among incident light is gathered by the light gathering unit, the gathered light from reaching the light sensing plane, an angle between the first incident light and a normal line of the light sensing plane being less than an angle threshold, the angle threshold being less than 90°, and the light sensing unit detects an illumination intensity of light reaching the light sensing plane.

EP 4 772 845 A2

## Description

TECHNICAL FIELD

Embodiments of the present disclosure relate to the technical field of a light sensor, and particularly relate to a light sensor and an electronic device.

BACKGROUND

An ambient light sensor is widely used in an electronic device such as a smart phone, and can detect an ambient illumination intensity, so that the electronic device such as the smart phone can perform an operation, such as automatically adjusting display screen brightness based on the illumination intensity detected by the ambient light sensor.

An existing ambient light sensor is arranged under a display screen of the electronic device to detect illumination intensity of a direction of the display screen of the electronic device.

However, when light is incident on the display screen at different incident angles, light that reaches the ambient light sensor through the display screen is different, so that when light with a same illumination intensity is incident at different incident angles, the ambient light sensor detects different illumination intensities, and so that the electronic device fails to obtain an accurate illumination intensity, thereby affecting the user experience.

SUMMARY

In view of this, embodiments of the present disclosure provide a light sensor and an electronic device, to at least partially solve the above problems.

According to a first aspect of the embodiments of the present disclosure, a light sensor is provided, including: at least one light gathering unit, at least one light blocking unit, and a light sensing unit; wherein, in a direction perpendicular to a light sensing plane of the light sensing unit, each light gathering unit corresponds to at least one light blocking unit, and the light blocking unit corresponding to the light gathering unit is located between the light gathering unit and the light sensing plane; the light blocking unit is configured to block, after first incident light among incident light is gathered by the light gathering unit, the gathered light from reaching the light sensing plane, an angle between the first incident light and a normal line of the light sensing plane being less than an angle threshold, the angle threshold being less than 90°; and the light sensing unit is configured to detect illumination intensity of light reaching the light sensing plane.

In a possible implementation, each light gathering unit corresponds to one light blocking unit; a central axis of the light gathering unit is perpendicular to the light sensing plane, and the light blocking unit corresponding to the light gathering unit intersects with the central axis of the light gathering unit; and in the direction perpendicular to the light sensing plane, a projection of the light blocking unit on the light sensing plane is located within a projection of the light gathering unit on the light sensing plane.

In a possible implementation, the light sensor further includes: a dielectric layer; and the dielectric layer is arranged between the light gathering unit and the light sensing unit, and the at least one light blocking unit is arranged in the dielectric layer.

In a possible implementation, the light sensor further includes: a first filter layer; and the first filter layer is arranged between the dielectric layer and the light sensing unit.

In a possible implementation, the dielectric layer includes: a first sub-dielectric layer and a second sub-dielectric layer; the light sensor further includes: a second filter layer; and the second filter layer is arranged between the first sub-dielectric layer and the second sub-dielectric layer.

In a possible implementation, the light sensor further includes: an encapsulation layer; and the encapsulation layer is arranged on a surface of the dielectric layer, and the at least one light gathering unit is located in the encapsulation layer.

In a possible implementation, a refractive index of the light gathering unit is greater than a refractive index of the encapsulation layer, and a difference between the refractive index of the light gathering unit and the refractive index of the encapsulation layer is greater than a refractive index threshold, wherein the refractive index threshold is greater than or equal to 0.2.

In a possible implementation, the light blocking unit includes a circular light blocking unit, and in the direction perpendicular to the light sensing plane, a central axis of the light blocking unit corresponding to the light gathering unit coincides with the central axis of the light gathering unit.

In a possible implementation, a diameter of the light blocking unit is in a range of [1 $\mu m$, 10 $\mu m$], and/or a height of the light gathering unit is in a range of [0.5 $\mu m$, 8$\mu m$].

In a possible implementation, the light sensor includes a plurality of light gathering units arranged in an array.

In a possible implementation, an arrangement period of the light gathering unit is in a range of [4 $\mu m$, 40 $\mu m$], and an aperture size of the light gathering unit is in a range of [4 $\mu m$, 40 $\mu m$], wherein the arrangement period of the light gathering unit is greater than or equal to the aperture size of the light gathering unit.

In a possible implementation, in the direction perpendicular to the light sensing plane, a distance between the light gathering unit and a bottom surface of the light blocking unit corresponding to the light gathering unit is in a range of [5 $\mu m$, 30 $\mu m$], wherein the bottom surface of the light blocking unit is opposite to the light sensing plane.

In a possible implementation, the light sensor further includes: a light guiding layer arranged between the dielectric layer and the light sensing unit.

In a possible implementation, the light blocking unit includes a light reflecting layer or a light absorbing layer.

In a possible implementation, the light gathering unit includes a lens.

According to a second aspect of the embodiments of the present disclosure, an electronic device is provided, including: the light sensor according to the first aspect.

According to the light sensor provided in the embodiments of the present disclosure, the light sensor includes at least one light gathering unit, at least one light blocking unit, and a light sensing unit, wherein the light blocking unit is arranged between the light gathering unit and the light sensing unit, first incident light at an angle from a normal line of the light sensing plane less than an angle threshold among incident light is gathered by the light gathering unit, and then blocked by the light blocking unit from illuminating on the light sensing unit after passing through the light gathering unit, and incident light at an angle from the normal line of the light sensing plane greater than or equal to the angle threshold can normally illuminate on the light sensing unit after passing through the light gathering unit. Therefore, an illumination intensity of small-angle incident light detected by the light sensing unit becomes lower, while an illumination intensity of large-angle incident light detected by the light sensing unit remains unchanged. Therefore, when the light sensing unit detects an illumination intensity of incident light, under a same illumination intensity, there is small difference between the illumination intensity of the incident light incident at a large angle detected by the light sensing unit and that of the incident light incident at a small angle, so that highly accurate illumination intensities are detected by the light sensor, and the electronic device can obtain highly accurate illumination intensities, thereby improving the user experience through corresponding operations based on the highly accurate illumination intensities.

BRIEF DESCRIPTION OF DRAWINGS

To more clearly describe technical solutions of embodiments of the present disclosure or the prior art, drawings to be used in the description of the embodiments or the prior art will be briefly introduced below. Apparently, the drawings in the description below are merely some embodiments disclosed in the embodiments of the present disclosure. For those of ordinary skills in the art, other drawings may also be obtained based on these drawings.

FIG. 1 is a schematic diagram of a light sensor provided in an embodiment of the present disclosure;

FIG. 2 is a schematic diagram of light gathering provided in an embodiment of the present disclosure;

FIG. 3 is a schematic diagram of another light gathering provided in an embodiment of the present disclosure;

FIG. 4 is a schematic diagram of light incidence provided in an embodiment of the present disclosure;

FIG. 5 is a schematic diagram of another light sensor provided in an embodiment of the present disclosure;

FIG. 6 is a schematic diagram of a light sensor including a dielectric layer provided in an embodiment of the present disclosure;

FIG. 7 is a schematic diagram of a light sensor including a filter layer provided in an embodiment of the present disclosure;

FIG. 8 is a schematic diagram of another light sensor including a filter layer provided in an embodiment of the present disclosure;

FIG. 9 is a schematic diagram of a light sensor including an encapsulation layer provided in an embodiment of the present disclosure;

FIG. 10 is a schematic diagram of a display screen provided in an embodiment of the present disclosure;

FIG. 11 is a top view of a light sensor provided in an embodiment of the present disclosure;

FIG. 12 is a top view of another light sensor provided in an embodiment of the present disclosure;

FIG. 13 is a schematic diagram of still another light sensor provided in an embodiment of the present disclosure;

FIG. 14 is a schematic diagram of an electronic device provided in an embodiment of the present disclosure; and

FIG. 15 is a schematic diagram of a response rate of a light sensing unit provided in an embodiment of the present disclosure.

DETAILED DESCRIPTION

To enable those skilled in the art to better understand technical solutions of embodiments of the present disclosure, the technical solutions of the embodiments of the present disclosure will be clearly and completely described below with reference to the drawings in the embodiments of the present disclosure. Apparently, the described embodiments are merely some, instead of all, of the embodiments of the present disclosure. All other embodiments obtained by those of ordinary skills in the art based on some embodiments among the embodiments of the present disclosure should be encompassed within the scope of protection of the embodiments of the present disclosure.

The terms used in the present disclosure are intended merely to describe particular embodiments, and are not intended to limit the present disclosure. The singular forms of "a" and "the" used in the present disclosure and the appended claims are also intended to include plural forms, unless the context explicitly indicates other meanings. It should be further understood that the term "and/or" used herein refers to and includes any or all possible combinations of one or more associated recited items.

It should be understood that various kinds of information may be described by using the terms, such as first, second, and third, in the present disclosure, but the information should not be limited to these terms. These terms are merely used to distinguish between information of a same type. For example, the first information may also be referred to as the second information, and similarly, the second information may also be referred to as the first information, without departing from the scope of the present disclosure. Depending on the context, as used herein, the word "if" may be interpreted as "at the time of..." or "when..." or "in response to determining."

As mentioned above, an ambient light sensor is widely used in an electronic device such as a smart phone, and can detect an ambient illumination intensity, so that the electronic device such as the smart phone can perform an operation, such as automatically adjusting display screen brightness based on the illumination intensity detected by the ambient light sensor. An existing ambient light sensor is arranged under a display screen of the electronic device to detect an illumination intensity of direction of the display screen of the electronic device. However, when light is incident on the display screen at different incident angles, light reaching the ambient light sensor through the display screen is different. For example, when an amount of light incident at an angle of 0 degrees from a normal line of the screen reaching the ambient light sensor is m, an amount of light incident at an angle of $\theta$ from the normal line of the screen reaching the ambient light sensor is m $*cos\theta$, that is, an amount of light incident at a large angle reaching the ambient light sensor is small, so that the ambient light sensor detects different illumination intensities for light with a same illumination intensity at different incident angles, and so that the electronic device fails to perform corresponding operations based on an accurate illumination intensity, for example, failing to accurately adjust the screen brightness of the electronic device, thereby affecting the user experience.

The present disclosure provides a light sensor, including at least one light gathering unit, at least one light blocking unit, and a light sensing unit, wherein the light blocking unit is arranged between the light gathering unit and the light sensing unit, first incident light at an angle from a normal line of the light sensing plane less than an angle threshold among incident light is gathered by the light gathering unit, and then blocked by the light blocking unit from illuminating on the light sensing unit, and incident light at an angle from the normal line of the light sensing plane greater than or equal to the angle threshold can normally illuminate on the light sensing unit after passing through the light gathering unit. Therefore, an illumination intensity of small-angle incident light detected by the light sensing unit becomes lower, while an illumination intensity of large-angle incident light detected by the light sensing unit remains unchanged. Therefore, when the light sensing unit detects an illumination intensity of incident light, under a same illumination intensity, there is small difference between the illumination intensity of the incident light incident at a large angle detected by the light sensing unit and the illumination intensity of the incident light incident at a small angle, so that highly accurate illumination intensities are detected by the light sensor, and the electronic device can obtain highly accurate illumination intensities, thereby improving the user experience through corresponding operations based on the highly accurate illumination intensities.

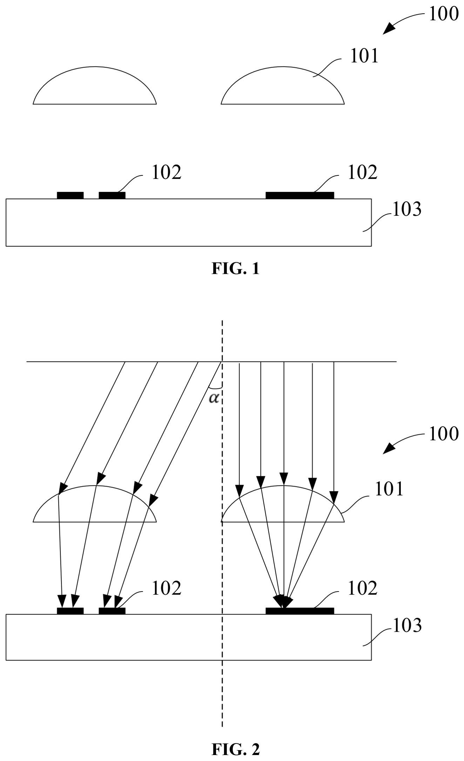

FIG. 1 is a schematic diagram of a light sensor provided in an embodiment of the present disclosure. As shown in FIG. 1, the light sensor 100 includes at least one light gathering unit 101, at least one light blocking unit 102, and a light sensing unit 103, wherein, in a direction perpendicular to a light sensing plane of the light sensing unit 103, each light gathering unit 101 corresponds to at least one light blocking unit 102, and the light blocking unit 102 corresponding to the light gathering unit 101 is located between the light gathering unit 101 and the light sensing plane; the light blocking unit 102 can block, after first incident light among incident light is gathered by the light gathering unit 101, the gathered light from reaching the light sensing plane 103, an angle between the first incident light and a normal line of the light sensing plane being less than an angle threshold, the angle threshold being less than 90°, and the light sensing unit 103 can detect an illumination intensity of light reaching the light sensing plane.

The light sensor 100 includes at least one light gathering unit 101, at least one light blocking unit 102, and a light sensing unit 103, wherein the light blocking unit 102 is arranged between the light gathering unit 101 and the light sensing unit 103, and at least one light blocking unit 102 is included between each of the light gathering unit 101 and the light sensing unit 103. In an example, when a plurality of light blocking units 102 are included between each light gathering unit 101 and the light sensing unit 103, the plurality of light blocking units 102 may be arranged in parallel on a same plane and spliced together to form a large light blocking unit 102, or the plurality of light blocking units 102 may be scattered in parallel on a same plane, or the plurality of light blocking units 102 may be arranged on different planes, which is not limited here.

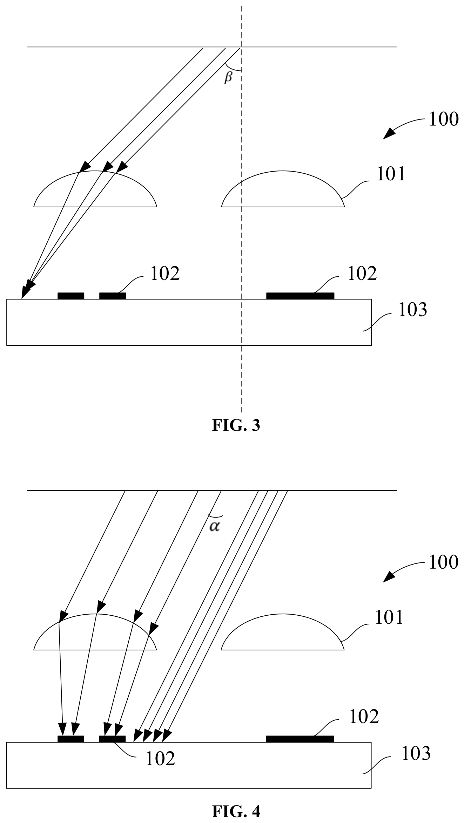

The light gathering unit 101 can gather light. Specifically, after light illuminates on the light gathering unit 101, the light is refracted, thereby changing the transmission direction. Light illuminating on the light gathering unit 101 at different positions will be gathered, and the light blocking unit 102 can block the gathered light. FIG. 2 is a schematic diagram of light gathering provided in an embodiment of the present disclosure. As shown in FIG. 2, after light is transmitted to the light gathering unit 101, the light through the light gathering unit 101 is refracted, thereby changing the light transmission direction. The light blocking unit 102 is arranged between the light gathering unit 101 and the light sensing unit 103, which are opposite to the light blocking unit 102. First incident light is refracted after passing through the light gathering unit 101, thereby changing its propagation direction. The light illuminates on the light blocking unit 102, and is blocked by the light blocking unit 102 from illuminating on the light sensing unit 103. The first incident light is light at an angle from a normal line of the light sensing plane less than an angle threshold. For example, FIG. 2 shows first incident light at an angle of $\alpha$ and first incident light at an angle of 0°, i.e., perpendicularly incident first incident light, respectively, with the angle $\alpha$ between the first incident light and the normal line less than the angle threshold. FIG. 3 is another schematic diagram of light gathering provided in an embodiment of the present disclosure. As shown in FIG. 3, second incident light at an angle from the normal line of the light sensing plane greater than or equal to the angle threshold among the incident light will not be blocked by the light blocking unit 102 after passing through the light gathering unit 101, and will directly illuminate on the light sensing unit 103, that is, angle $\beta$ in FIG. 3 is greater than or equal to the angle threshold. It should be understood that due to the characteristics of light, light at an angle of more than 90° from the normal line of the light sensing plane will not illuminate on the light sensing plane, so that the angle threshold is less than 90°.

The light sensing unit 103 can detect an intensity of light reaching the light sensing plane of the light sensing unit 103. It should be noted that due to the existence of the light blocking unit 102, light of the first incident light at an angle from the normal line of the light sensing plane less than the angle threshold is blocked by the light blocking unit 102 after passing through the light sensing plane 101, while the second incident light at an angle from the normal line of the light sensing plane greater than or equal to the angle threshold will not be blocked by the light blocking unit 102 after passing through the light sensing plane 101, and can directly illuminate on the light sensing plane.

It should also be noted that the light sensing unit 103 of the light sensor 100 in an embodiment of the present disclosure is not completely covered by the at least one light gathering unit 101. Therefore, partial light among the first incident light at an angle from the normal line of the light sensing plane less than the angle threshold does not pass through the light gathering unit 101, but can illuminate on the light sensing plane through a position where the light collecting unit 101 is not provided. For example: FIG. 4 is a schematic diagram of light incidence provided in an embodiment of the present disclosure. As shown in FIG. 4, partial light among the first incident light at an angle of $\alpha$ illuminates on the light sensing plane through a spacing between the light gathering units 101. Therefore, the light sensor 100 in an embodiment of the present disclosure reduces an amount of light among the first incident light at an angle from the normal line of the light sensing plane less than the angle threshold reaching the light sensing plane, instead of completely blocking the first incident light. However, an amount of light among the second incident light at an angle from the normal line of the light sensing plane greater than or equal to the angle threshold reaching the light sensing plane remains unchanged. Therefore, the light sensor 100 in an embodiment of the present disclosure keeps an illumination intensity of detected large-angle incident light unchanged while reducing an illumination intensity of detected small-angle incident light.

In an embodiment of the present disclosure, the light sensor 100 includes at least one light gathering unit 101, at least one light blocking unit 102, and a light sensing unit 103, wherein the light blocking unit 102 is arranged between the light gathering unit 101 and the light sensing unit 103, first incident light at an angle from a normal line of the light sensing plane less than an angle threshold among incident light is gathered by the light gathering unit 101, and then blocked by the light blocking unit 102 from illuminating on the light sensing unit 103, and incident light at an angle from the normal line of the light sensing plane greater than or equal to the angle threshold can normally illuminate on the light sensing unit 103 after passing through the light gathering unit 101. Therefore, an illumination intensity of small-angle incident light detected by the light sensing unit 103 becomes lower, while an illumination intensity of large-angle incident light detected by the light sensing unit 103 remains unchanged. Therefore, when the light sensing unit 103 detects an illumination intensity of the incident light, under a same illumination intensity, there is small difference between the illumination intensity of the incident light incident at a large angle detected by the light sensing unit 103 and the illumination intensity of the incident light incident at a small angle, so that highly accurate illumination intensities are detected by the light sensor 100, and the electronic device obtains highly accurate illumination intensities, thereby improving the user experience through corresponding operations based on the highly accurate illumination intensities.

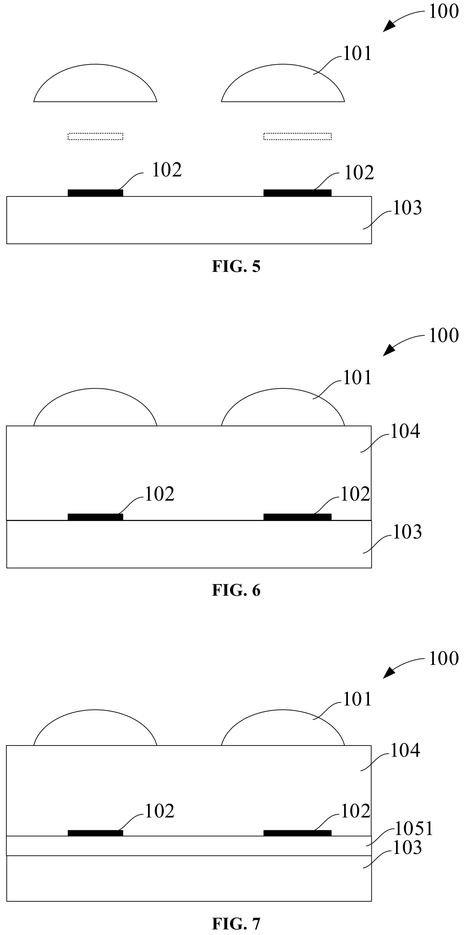

FIG. 5 is a schematic diagram of another light sensor provided in an embodiment of the present disclosure. As shown in FIG. 5, each light gathering unit 101 corresponds to one light blocking unit 102, a central axis of the light gathering unit 101 is perpendicular to the light sensing plane, the light blocking unit 102 corresponding to the light gathering unit 101 intersects with the central axis of the light gathering unit 101, and in the direction perpendicular to the light sensing plane, a projection of the light blocking unit 102 on the light sensing plane is located within a projection of the light gathering unit 101 on the light sensing plane.

Only one light blocking unit 102 is arranged between each light gathering unit 101 and the light sensing plane. The light blocking unit 102 may be a light blocking unit 102 of various shapes. For example, the light blocking unit 102 may be, e.g., a square light blocking unit 102 or a circular light blocking unit 102. The light blocking unit 102 may be arranged at any position on the light gathering unit 101 and the light sensing plane. For example, when arranged at the solid line position in FIG. 5, the light blocking unit 102 contacts with the light sensing plane, and when arranged at the dotted line position in FIG. 5, the light blocking unit 102 does not contact with the light sensing plane. The light blocking unit 102 corresponding to different light gathering units 101 may be arranged at different positions.

It should be understood that, the light blocking unit 102 needs to block the incident light incident at a small angle, that is, to block light of the first incident light at an angle from the normal line of the light sensing plane less than the angle threshold among the incident light after passing through the light gathering unit 101, and the first incident light is generally gathered around the central axis of the light gathering unit 101 after passing through the light gathering unit 101, so that the light blocking unit 102 corresponding to the light gathering unit 101 intersects with the central axis of the light gathering unit 101. It should also be noted that, the second incident light at an angle from the normal line of the light sensing plane greater than or equal to the angle threshold among the incident light is generally gathered at an edge position of the light gathering unit 101 after passing through the light gathering unit 101, so that in the direction perpendicular to the light sensing plane, the projection of the light blocking unit 102 on the light sensing plane is located within the projection of the light gathering unit 101 on the light sensing plane, that is, viewed from the light gathering unit 101 towards the light sensing plane, the light blocking unit 102 does not exceed the corresponding light gathering unit 101.

In an embodiment of the present disclosure, each light gathering unit 101 corresponds to a light blocking unit 102, and the light blocking unit 102 corresponding to the light gathering unit 101 intersects with the central axis of the light gathering unit 101, so that the light blocking unit 102 can block light generated after the first incident light passes through the light gathering unit 101, that is, block small-angle incident light, and in the direction perpendicular to the light sensing plane, the projection of the light blocking unit 102 on the light sensing plane is located within the projection of the light gathering unit 101 on the light sensing plane, thereby preventing the light blocking unit 102 from blocking large-angle incident light, preventing the light blocking unit 102 from exceeding the light gathering unit 101 so that the incident light at a position where no light gathering unit 101 is provided is blocked by the light blocking unit 102, and improving the accuracy of the illumination intensity detected by the light sensor 100.

FIG. 6 is a schematic diagram of a light sensor including a dielectric layer provided in an embodiment of the present disclosure. As shown in FIG. 6, the light sensor 100 further includes a dielectric layer 104, the dielectric layer 104 is arranged between the light gathering unit 101 and the light sensing unit 103, and the at least one light blocking unit 102 is arranged in the dielectric layer 104.

The dielectric layer 104 is arranged between the light gathering unit 101 and the light sensing unit 103. In an example, as shown in FIG. 6, the light gathering unit 101 is arranged on a first surface of the dielectric layer 104, the light sensing unit 103 is arranged on a second surface of the dielectric layer 104, and the light blocking unit 102 is arranged in the dielectric layer 104 and is located between the light gathering unit 101 and the light sensing unit 103, that is, the light blocking unit 102 is arranged between the first surface and the second surface of the dielectric layer 104.

In an embodiment of the present disclosure, a dielectric layer 104 is further included between the light gathering unit 101 and the light sensing unit 103. The dielectric layer 104 can provide a light transmission medium. After the dielectric layer 104 is filled, the light gathering unit 101 has a similar light refractive index to the dielectric layer 104, thereby preventing light propagation direction changes of light emitted from the light gathering unit 101 due to the difference between light refractive index of air and the light refractive index of the light gathering unit 101. Moreover, the dielectric layer 104 can seal the light sensing plane of the light sensing unit 103, thereby preventing the light sensing plane of the light sensing unit 103 from being affected by a foreign matter.

FIG. 7 is a schematic diagram of a light sensor including a filter layer provided in an embodiment of the present disclosure. As shown in FIG. 7, the light sensor 100 further includes a first filter layer 1051, and the first filter layer 1051 is arranged between the dielectric layer 104 and the light sensing unit 103.

The light sensor 100 further includes the first filter layer 1051, the first filter layer 1051 is arranged between the dielectric layer 104 and the light sensing unit 103, a first surface of the first filter layer 1051 contacts with a second surface of the dielectric layer 104, a second surface of the first filter layer 1051 contacts with a light sensing plane of the light sensing unit 103, and the first filter layer 1051 may be, e.g., a color filter layer or an infrared filter layer.

In an embodiment of the present disclosure, the light sensor 100 further includes the first filter layer 1051, and the first filter layer 1051 is arranged between the dielectric layer 104 and the light sensing unit 103, so that the light sensor 100 detects an illumination intensity of particular light. When the first filter layer 1051 is the color filter layer, the light sensor 100 can detect an illumination intensity of infrared light. When the first filter layer 1051 is the infrared filter layer, the light sensor 100 can detect an illumination intensity of natural light, thereby satisfying different detection requirements.

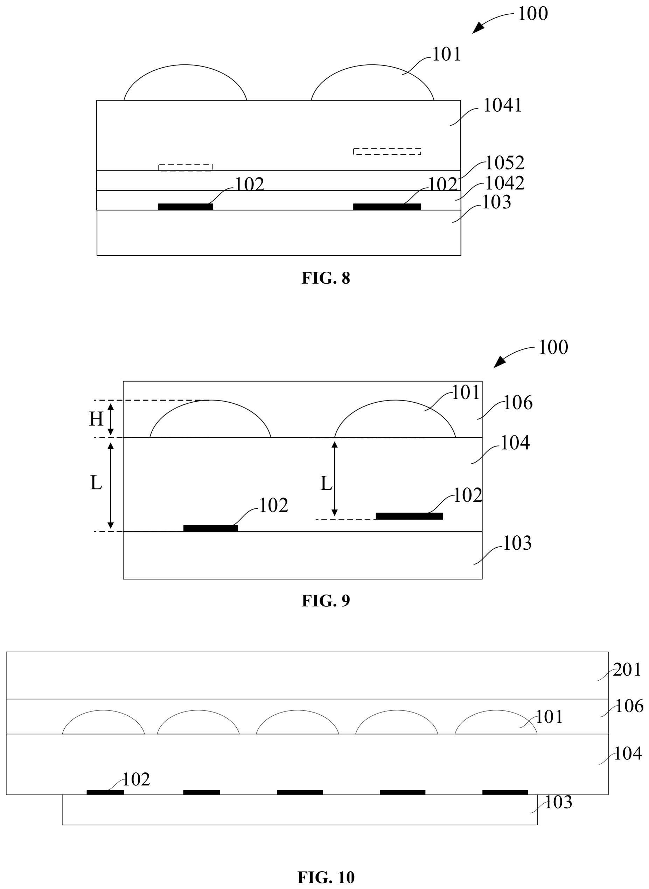

FIG. 8 is a schematic diagram of a light sensor including a filter layer provided in an embodiment of the present disclosure. As shown in FIG. 8, the dielectric layer 104 includes a first sub-dielectric layer 1041 and a second sub-dielectric layer 1042, the light sensor 100 further includes a second filter layer 1052, and the second filter layer 1052 is arranged between the first sub-dielectric layer 1041 and the second sub-dielectric layer 1042.

The light sensor 100 may include the second filter layer 1052, and the second filter layer 1052 is arranged between the first sub-dielectric layer 1041 and the second sub-dielectric layer 1042. In an example, the light blocking unit 102 may be arranged in the first sub-dielectric layer 1041, as shown by the dotted line in FIG. 8, that is, the light blocking unit 10 2 may be arranged between the light gathering unit 101 and the second filter layer 1052. In another example, the light blocking unit 102 may be arranged in the second sub-dielectric layer 1042, as shown by the solid line in FIG. 8, that is, the light blocking unit 102 may be arranged between the second filter layer 1052 and the light sensing plane of the light sensing unit 103.

It should be noted that, when each light gathering unit 101 corresponds to a plurality of light blocking units 102, the light blocking units 102 corresponding to each light gathering unit 101 may be arranged in the first sub-dielectric layer 1041 and/or the second sub-dielectric layer 1042; when each light gathering unit 101 corresponds to a single light blocking unit 102, the light blocking unit 102 may be arranged in the first sub-dielectric layer 10 41 or the second sub-dielectric layer 1042, and the light blocking units 102 corresponding to different light gathering units 101 may be arranged at different positions. For example, a light blocking unit 102 corresponding to a first light gathering unit 101 may be arranged in the first sub-dielectric layer 1041, and a light blocking unit 102 corresponding to a second light gathering unit 101 may be arranged in the second sub-dielectric layer 1042, etc. When the light blocking unit 102 is arranged in the first sub-dielectric layer 1041 and/or the second sub-dielectric layer 1042, in the direction perpendicular to the light sensing plane, the first sub-dielectric layer 1041 and the second sub-dielectric layer 1042 each have a length greater than the light blocking unit 102, that is, the light blocking unit 102 is arranged in the first sub-dielectric layer 1041 and/or the second sub-dielectric layer 1042, without exceeding the dielectric layer 104.

In an embodiment of the present disclosure, the dielectric layer 104 includes: a first sub-dielectric layer 1041 and a second sub-dielectric layer 1042, and the light sensor 100 further includes a second filter layer 1052, so that the light sensor 100 can detect a particular illumination intensity. When the second filter layer 1052 is a color filter layer, the illumination intensity of infrared light can be detected by the light sensor 100. When the second filter layer 1052 is an infrared filter layer, the illumination intensity of natural light can be detected by the light sensor 100, thereby satisfying different detection requirements.

FIG. 9 is a schematic diagram of a light sensor including an encapsulation layer provided in an embodiment of the present disclosure. As shown in FIG. 9, the light sensor 100 further includes the encapsulation layer 106, the encapsulation layer 106 is arranged on a surface of the dielectric layer 104, and at least one gathering unit 101 is located in the encapsulation layer 106.

The light sensor 100 further includes the encapsulation layer 106, the encapsulation layer 106 encapsulates the light gathering unit 101, the dielectric layer 104, and the light sensing unit 103, each light gathering unit 101 is located in the encapsulation layer 106, and in the direction perpendicular to the light sensing plane, projections of the light gathering unit 101, the dielectric layer 104, the light blocking unit 102, and the light sensing unit 103 are located within the projection of the encapsulation layer 106. FIG. 10 is a schematic diagram of a display screen provided in an embodiment of the present disclosure. As shown in FIG. 10, the light sensor 100 is arranged under the display screen 201, and all of the light gathering units 101 are located in the encapsulation layer 106. The encapsulation layer 106 covers the light gathering unit 101, the dielectric layer 104, the light blocking unit 102, and the light sensing unit 103.

In an embodiment of the present disclosure, the light sensor 100 further includes the encapsulation layer 106, and the encapsulation layer 106 is arranged on a surface of the dielectric layer 104, thereby encapsulating the light sensor 100 through the encapsulation layer 106, preventing a foreign matter from affecting the light sensor 100, and improving the reliability of the light sensor 100.

In a possible implementation, a refractive index of the light gathering unit 101 is greater than a refractive index of the encapsulation layer 106, and a difference between the refractive index of the light gathering unit 101 and the refractive index of the encapsulation layer 106 is greater than a refractive index threshold, wherein the refractive index threshold is greater than or equal to 0.2.

After the encapsulation layer 106 encapsulates the light sensor 100, a plurality of light gathering units 101 are located in the encapsulation layer 106. In this case, in order to enable the light gathering unit 101 to have its original light gathering effect, the difference between the refractive index of the light gathering unit 101 and the refractive index of the encapsulation layer 106 is greater than the refractive index threshold, which may be greater than or equal to 0.2. Specifically, when the refractive index of the light gathering unit 101 is different from that of the encapsulation material, the light gathering unit 101 can function to gather light, that is, gather light through the light gathering unit 101.

In an example, the light gathering unit 101 may be made of a material with a high refractive index, i.e., the light gathering unit 101 is made of a material with a refractive index n>1.6, and the encapsulation layer 106 is made of a material with a normal refractive index, i.e., the encapsulation layer 106 is made of a material with a refractive index satisfying $1.4 \leq n \leq 1.6$. However, the difference between the refractive index of the light gathering unit 101 and the refractive index of the encapsulation layer 106 needs to be greater than the refractive index threshold. In another example, the light gathering unit 101 may be made of a material with a normal refractive index, i.e., the light gathering unit 101 is made of a material with a refractive index satisfying $1.4 \leq n \leq 1.6$, and then the encapsulation layer 106 is made of a material with a low refractive index, i.e., the encapsulation layer 106 is made of a material with a refractive index n<1.4, but the difference between the refractive index of the light gathering unit 101 and the refractive index of the encapsulation layer 106 needs to be greater than the refractive index threshold. In still another example, the light gathering unit 101 may be made of a material with a high refractive index, i.e., the light gathering unit 101 is made of a material with a refractive index n>1.6, and then the encapsulation layer 106 is made of a material with a low refractive index, i.e., the encapsulation layer 106 is made of a material with a refractive index n<1.4, but the difference between the refractive index of the light gathering unit 101 and the refractive index of the encapsulation layer 106 needs to be greater than the refractive index threshold. In an example, the refractive index threshold may be greater than or equal to 0.2.

In an embodiment of the present disclosure, the refractive index of the light gathering unit 101 is greater than the refractive index of the encapsulation layer 106, and the difference between the refractive index of the light gathering unit 101 and the refractive index of the encapsulation layer 106 is greater than the refractive index threshold, so that the light gathering unit 101, when located in the encapsulation layer 106, still has a light gathering effect, thereby gathering the first incident light at an angle from the normal line of the light sensing plane less than the angle threshold at a position of the light blocking unit 102 after passing through the light gathering unit 101. The light blocking unit 102 can block the gathered light from illuminating on the light sensing plane, thereby weakening an illumination intensity of the small-angle incident light detected by the light sensing unit 103.

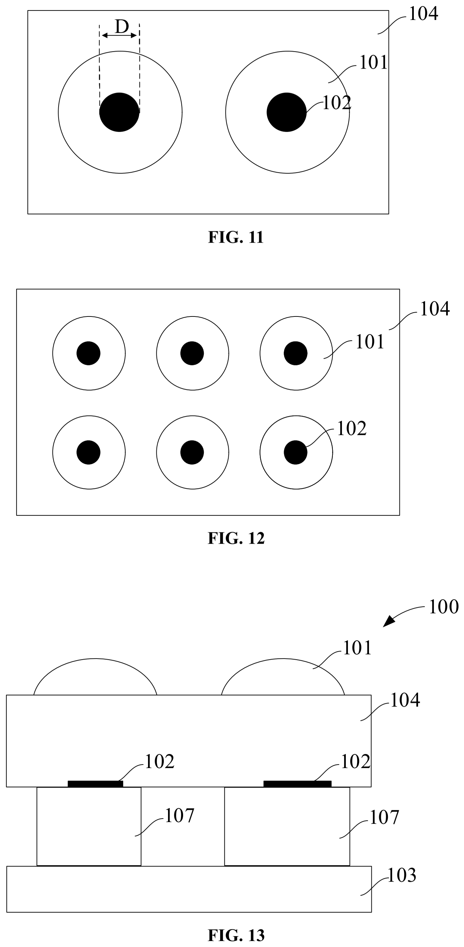

FIG. 11 is a top view of a light sensor provided in an embodiment of the present disclosure. As shown in FIG. 11, the light blocking unit 102 includes a circular light blocking unit 102, and in the direction perpendicular to the light sensing plane, a central axis of the light blocking unit 101 corresponding to the light gathering unit 102 coincides with the central axis of the light gathering unit 101.

In an embodiment of the present disclosure, the light blocking unit 102 includes a circular light blocking unit 102, and in the direction perpendicular to the light sensing plane, the central axis of the light blocking unit 101 corresponding to the light gathering unit 102 coincides with the central axis of the light gathering unit 101, thereby blocking light gathered at a position in the vicinity of the axis after passing through the light gathering unit 101, blocking the first incident light at an angle from the normal line of the light sensing plane less than the angle threshold, and weakening the illumination intensity of the small-angle incident light detected by the light sensing unit 103.

In a possible implementation, a diameter of the light blocking unit 102 is in a range of [1 $\mu m$, 10 $\mu m$], and/or a height of the light gathering unit 101 is in a range of [0.5 $\mu m$, 8$\mu m$].

As shown in FIG. 11, when the light blocking unit 102 is circular, the diameter D of the light blocking unit 102 is in the range of [1 $\mu m$, 10 $\mu m$], and/or, as shown in FIG. 9, the height H of the light gathering unit 101 is in the range of [0.5 $\mu m$, 8 $\mu m$], and the height of the light gathering unit 101 is a distance from the top of a lens to a surface of the dielectric layer 104 in contact with the light gathering unit 101. In a preferred example, the height of the light gathering unit 101 is in the range of [1 $\mu m$, 5 $\mu m$].

In an embodiment of the present disclosure, the diameter of the light blocking unit 102 is in the range of [1 $\mu m$, 10 $\mu m$], and/or, the height of the light gathering unit 101 is in the range of [0.5 $\mu m$, 8 $\mu m$]. Light gathered from the first incident light at an angle from the normal line of the light sensing plane smaller than the angle threshold after passing through the light gathering unit 101 can be successfully blocked by the light blocking unit 102, thereby weakening the illumination intensity of the small-angle incident light detected by the light sensing unit 103, to improve the accuracy of the illumination intensity detected by the light sensor 100.

FIG. 12 is a top view of another light sensor provided in an embodiment of the present disclosure. As shown in FIG. 12, the light sensor 100 includes a plurality of light gathering units 101, and the plurality of light gathering units 101 are arranged in an array.

When the light sensor 100 includes the plurality of light gathering units 101, the plurality of light gathering units 101 are arranged in an array. In an example, as shown in FIG. 12, the plurality of light gathering units 101 are arranged periodically in a square shape to form the array of the light gathering units 101. It should be understood that since the first incident light at an angle from the normal line of the light sensing plane less than the angle threshold will be blocked by the light blocking unit 102 after passing through the light gathering unit 101. Therefore, there may be a certain spacing between any adjacent light gathering units 101, and the first incident light at an angle from the normal line of the light sensing plane less than the angle threshold illuminates on a portion where no light gathering unit is provided, for example, directly illuminates on the light sensing plane between any adjacent light gathering units 101 or positions where no light gathering unit is provided, thereby detecting the illumination intensity of the first incident light at an angle from the normal line of the light sensing plane less than the angle threshold.

In an embodiment of the present disclosure, the light sensor 100 includes a plurality of light gathering units 101, and the plurality of light gathering units 101 are arranged in an array, thereby arranging the plurality of light gathering units 101 on the light sensor 100.

In a possible implementation, an arrangement period of the light gathering unit 101 is in a range of [4 $\mu m$, 40 $\mu m$], and an aperture size of the light gathering unit 101 is in a range of [4 $\mu m$, 40 $\mu m$], wherein the arrangement period of the light gathering unit is greater than or equal to the aperture size of the light gathering unit 101.

The arrangement period of the light gathering unit 101 refers to a distance between centers of two adjacent light gathering units 101 in the array of the light gathering unit 101, the aperture size of the light gathering unit 101 refers to an effective light transmission diameter of the light gathering unit 101, the arrangement period of the light gathering unit 101 is in the range of [4 $\mu m$, 40 $\mu m$], and the aperture size of the light gathering unit 101 is in the range of [4 $\mu m$, 40 $\mu m$]. It should be understood that there may be a certain spacing between adjacent light gathering units 101, and the spacing between adjacent light gathering units 101 is equal to a difference between the arrangement period of the light gathering units 101 and the aperture size of the light gathering unit 101, so that the arrangement period of the light gathering unit 101 needs to be greater than or equal to the aperture size of the light gathering unit 101. In a preferred example, the arrangement period of the light gathering unit 101 is in a range of [5 $\mu m$, 25 $\mu m$], and the aperture size of the light gathering unit 101 is in a range of [5 $\mu m$, 25 $\mu m$], wherein the arrangement period of the light gathering unit 101 is greater than or equal to the aperture size of the light gathering unit 101.

In an embodiment of the present disclosure, the arrangement period of the light gathering unit 101 is in the range of [4 $\mu m$, 40 $\mu m$], and the aperture size of the light gathering unit 101 is in the range of [4 $\mu m$, 40 $\mu m$], so that the plurality of light gathering units 101 may be arranged in an array. When the arrangement period of the light gathering unit 101 is greater than the aperture size of the light gathering unit 101, there may be a certain spacing between any adjacent light gathering units 101, so that partial light among the first incident light can illuminate on the light sensing plane of the light sensing unit 103 through the spacing between adjacent light gathering units 101 or positions where no light gathering unit 101 is provided. When the arrangement period of the light gathering unit 101 is equal to the aperture size of the light gathering unit 101, the light gathering units 101 are closely arranged, so that partial light among the first incident light illuminates on the light sensing plane of the light sensing unit 103 through the spacing among the plurality of closely arranged light gathering units 101 or positions where no light gathering unit 101 is provided, and so that the light sensing unit 103 can detect the illumination intensity of the first incident light at an angle from the normal line of the light sensing plane less than the angle threshold, thus detecting the illumination intensity of the small-angle incident light.

In a possible implementation, in the direction perpendicular to the light sensing plane, a distance between the light gathering unit 101 and a bottom surface of the light blocking unit 102 corresponding to the light gathering unit 101 is in a range of [5 $\mu m$, 30 $\mu m$], wherein the bottom surface of the light blocking unit 102 is opposite to the light sensing plane.

The light blocking unit 102 is arranged inside the dielectric layer 104, the light blocking unit 102 has a certain thickness, the light gathering unit 101 is arranged on a surface of the dielectric layer 104, an upper surface of the light blocking unit 102 is opposite to the light gathering unit 101, the bottom surface of the light blocking unit 102 is opposite to the light sensing plane, and the distance between the bottom surface of the light blocking unit 102 and the light gathering unit 101 is in the range of [5 $\mu m$, 30 $\mu m$], for example: the distance L in FIG. 9.

In an example, dimensions of portions of the light sensor 100 can satisfy the following formulas (1) to (3):

$$0 \leq \frac{CD_{ulens}}{CA_{ulens}} \leq 0.5 \quad (1)$$

$$1 \leq \frac{L + 0.78 * H_{ulens}}{0.78 * ROC_{ulens}} \leq 5 \quad (2)$$

$$1 \leq \frac{P_{ulens} + 0.67 * H_{ulens} - \frac{D}{2}}{0.67 * ROC_{ulens}} \leq 5 \quad (3)$$

*P_ulens* is used to represent the period of the light gathering unit 101, *CA_ulens* is used to represent the aperture size of the light gathering unit 101, *H_ulens* is used to represent the height of the light gathering unit 101, *CD_ulens* is used to represent the spacing between adjacent light gathering units 101, L is used to represent the distance between the light gathering unit 101 and the bottom surface of the corresponding light blocking unit 102, D is used to represent the diameter of the light blocking unit 102, and *ROC_ulens* is used to represent radius of curvature of the light gathering unit 101, wherein the *ROC_ulens* can be calculated as per the following formula (4):

$$ROC_{ulens} = \frac{CA_{ulens}^2}{8 * H_{ulens}} + \frac{1}{2}H_{ulens} \qquad (4)$$

In an embodiment of the present disclosure, the distance between the light gathering unit 101 and the bottom surface of the light blocking unit 102 corresponding to the light gathering unit 101 is in the range of [5 μm, 30 μm], and the light blocking unit 102 may be arranged in the dielectric layer 104. Because the light blocking unit 102 needs to block light among the first incident light at an angle from the normal line of the light sensing plane less than the angle threshold after passing through the light gathering unit 101, and the light gathering unit 101 will gather the light passing through the light gathering unit 101 on a focal plane corresponding to the light gathering unit 101, the distance between the light gathering unit 101 and the bottom surface of the light blocking unit 102 is adjusted, thereby adjusting a relative position between the light blocking unit 102 and the focal plane of the light gathering unit 101, adjusting an amount of light blocked by the light blocking unit 102, blocking light as required, and adjusting the weakening degree of the small-angle incident light.

FIG. 13 is a schematic diagram of still another light sensor provided in an embodiment of the present disclosure. As shown in FIG. 13, the light sensor 100 further includes a light guiding layer 107, and the light guiding layer 107 is arranged between the dielectric layer 104 and the light sensing unit 103.

The light sensor 100 further includes the light guiding layer 107 or a light scattering layer. The light guiding layer 107 may be a light guide, such as a cylinder. The light gathering unit 101 and the light blocking unit 102 are arranged on an external light guide. It should be noted that since the light gathering unit 101 and the light blocking unit 102 are arranged on the external light guide, the light sensing unit 103 may be encapsulated separately, and the light gathering unit 101 does not need to be arranged in the encapsulation layer 106. It should be noted that FIG. 13 only serves as an example, and should not impose any limitation on this embodiment. The specific shape and arrangement position of the light sensing unit 103 may be set as required.

In an embodiment of the present disclosure, the light sensor 100 further includes the light guiding layer 107, and the light guiding layer 107 is arranged between the dielectric layer 104 and the light sensing unit 103. Therefore, the light gathering unit 101 and the light blocking unit 102 may be arranged on the external light guide, so that the light sensing unit 103 is encapsulated separately, and the light gathering unit 101 and the light blocking unit 102 are arranged outside the light sensing unit 103, thereby reducing the thickness of the light sensor 100.

In a possible implementation, the light blocking unit 102 includes a light reflecting layer or a light absorbing layer.

The light blocking unit 102 may include the light reflecting layer, which can reflect light to serve for blocking light. In an example, the light reflecting layer may be a metal material. For example, metal wiring of the light sensing unit 103 or a metal layer in the light sensing unit 103 may be used as the light reflecting layer. The light blocking unit 102 may further include a light absorbing layer, which can absorb light to serve for blocking light. In an example, the light absorbing layer may be a black material or a coating, which may be provided in the dielectric layer 104 and/or on a surface of the light sensing plane of the light sensing unit 103 to arrange the light blocking unit 102.

In an embodiment of the present disclosure, the light blocking unit 102 includes a light reflecting layer or a light absorbing layer, so that the light blocking unit 102 can block light among the first incident light at an angle from the normal line of the light sensing plane smaller than the angle threshold after passing through the light gathering unit 101, thereby weakening the illumination intensity of the detected small-angle incident light, and making the light sensing unit 103 detect an illumination intensity of external ambient light more accurately.

In a possible implementation, the light gathering unit 101 includes a lens.

The light gathering unit 101 may be the lens. In some other implementations, the light gathering unit 101 may further be a device with a light gathering function, such as a Fresnel zone plate or a superlens.

In an embodiment of the present disclosure, the light gathering unit 101 includes the lens, thereby achieving the light gathering function of the light gathering unit 101.

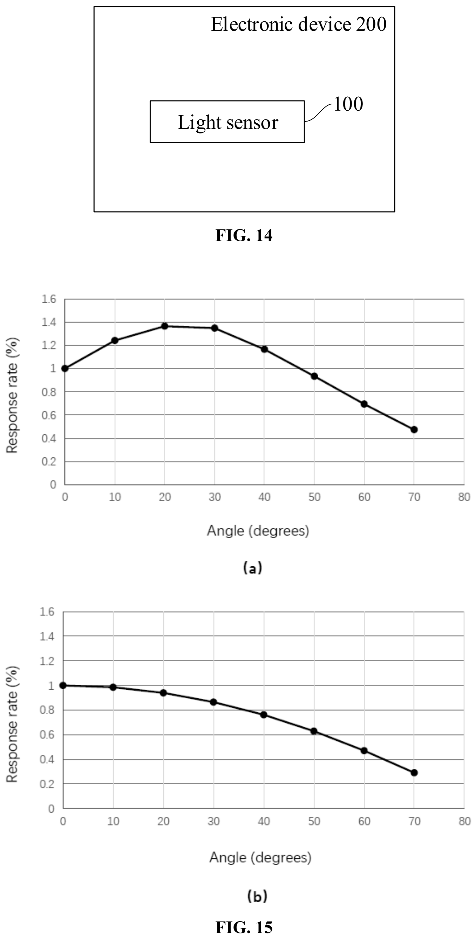

FIG. 14 is a schematic diagram of an electronic device provided in an embodiment of the present disclosure. As shown in FIG. 14, the electronic device 200 includes the light sensor 100 in any one of the above embodiments. In an example, the light sensor 100 may be arranged under a display screen of the electronic device 200, a light sensing plane is opposite to the display screen to detect an illumination intensity of light from a direction of the display screen. In another example, the light sensor 100 may be arranged at an additional position in the electronic device 200 to detect an illumination intensity in a corresponding direction. The specific arrangement position is not limited here.

FIG. 15 is a schematic diagram of a response rate of a light sensing unit provided in an embodiment of the present disclosure. As shown in FIG. 15, FIG. 15 (b) is a light response rate in the prior art, and FIG. 15 (a) is a response rate of the light sensing unit using the solutions of the embodiments of the present disclosure. The ordinate in FIG. 15 is used to represent the response rate, and the abscissa in FIG. 15 is used to represent an angle between incident light and a normal line of a light sensing plane. As shown in FIG. 15, in the prior art, the response rate of the light sensing unit when incident light at an angle of 60° illuminates is 47% of the response rate of the light sensing unit when incident light at an angle of 0° illuminates. However, after the solutions of the present disclosure are used, the response rate of the light sensing unit when the incident light at the angle of 60° illuminates is 69% of the response rate of the light sensing unit when the incident light at the angle of 0° illuminates. In the prior art, the response rate of the light sensing unit when incident light at an angle of 70° illuminates is 29% of the response rate of the light sensing unit when the incident light at the angle of 0° illuminates. However, after the solutions of the present disclosure are used, the response rate of the light sensing unit when the incident light at the angle of 70° illuminates is 47% of the response rate of the light sensing unit when the incident light at the angle of 0° illuminates. Therefore, as can be seen from the schematic diagram of the response rate of the light sensing unit, the response rate of the light sensing unit when large-angle incident light illuminates is significantly improved compared to the prior art, thereby reducing the difference between the response rate of large-angle incident light and that of small-angle incident light.

It should be noted that, depending on the implementation requirements, the components/steps described in the embodiments of the present disclosure may be split \into more components/steps, or two or more components/steps or partial operations of the components/steps may be combined into novel components/-steps to achieve the goal of the embodiments of the present disclosure.

As will be appreciated by those of ordinary skills in the art, the various example units and method steps described in combination with the embodiments disclosed herein can be implemented by electronic hardware, or a combination of computer software and electronic hardware. Whether these functions are executed by hardware or software depends on particular applications and design constraints of the technical solutions. Those skilled in the art may implement the described functions for each particular application using different methods, but such implementation should not be considered as falling beyond the scope of the embodiments of the present disclosure.

The above embodiments are only used to illustrate the embodiments of the present disclosure, and are not intended to limit the embodiments of the present disclosure. Those of ordinary skills in the relevant technical field may further make various alterations and modifications without departing from the spirit and scope of the embodiments of the present disclosure. Therefore, all equivalent technical solutions are also encompassed within the scope of the embodiments of the present disclosure, and the scope of patent protection of the embodiments of the present disclosure should be defined by the claims.

## Claims

1. A light sensor, comprising: at least one light gathering unit, at least one light blocking unit, and a light sensing unit;

   wherein, in a direction perpendicular to a light sensing plane of the light sensing unit, each light gathering unit corresponds to at least one light blocking unit, and the light blocking unit corresponding to the light gathering unit is located between the light gathering unit and the light sensing plane;
   the light blocking unit is configured to block, after first incident light among incident light is gathered by the light gathering unit, the gathered light from reaching the light sensing plane, an angle between the first incident light and a normal line of the light sensing plane being less than an angle threshold, the angle threshold being less than 90°; and
   the light sensing unit is configured to detect an illumination intensity of light reaching the light sensing plane.

2. The light sensor according to claim 1, wherein each light gathering unit corresponds to one light blocking unit;

   a central axis of the light gathering unit is perpendicular to the light sensing plane, and the light blocking unit corresponding to the light gathering unit intersects with the central axis of the light gathering unit; and
   in the direction perpendicular to the light sensing plane, a projection of the light blocking unit on the light sensing plane is located within a projection of the light gathering unit on the light sensing plane.

3. The light sensor according to claim 1, wherein the light sensor further comprises:

   a dielectric layer; and the dielectric layer is arranged between the light gathering unit and the light sensing unit, and the at least one light blocking unit is arranged in the dielectric layer; or wherein the light sensor further comprises: a light guiding layer arranged between the dielectric layer and the light sensing unit.

4. The light sensor according to claim 3, wherein the light sensor further comprises:

a first filter layer; and
the first filter layer is arranged between the dielectric layer and the light sensing unit.

5. The light sensor according to claim 3, wherein the dielectric layer comprises: a first sub-dielectric layer and a second sub-dielectric layer;

   the light sensor further comprises: a second filter layer; and
   the second filter layer is arranged between the first sub-dielectric layer and the second sub-dielectric layer.

6. The light sensor according to claim 3, wherein the light sensor further comprises:
an encapsulation layer; and
the encapsulation layer is arranged on a surface of the dielectric layer, and the at least one light gathering unit is located in the encapsulation layer.

7. The light sensor according to claim 6, wherein a refractive index of the light gathering unit is greater than a refractive index of the encapsulation layer, and a difference between the refractive index of the light gathering unit and the refractive index of the encapsulation layer is greater than a refractive index threshold, wherein the refractive index threshold is greater than or equal to 0.2.

8. The light sensor according to claim 2, wherein the light blocking unit comprises a circular light blocking unit, and in the direction perpendicular to the light sensing plane, a central axis of the light blocking unit corresponding to the light gathering unit coincides with the central axis of the light gathering unit.

9. The light sensor according to claim 8, wherein a diameter of the light blocking unit is in a range of [1 $\mu m$, 10 $\mu m$], and/or a height of the light gathering unit is in a range of [0.5 $\mu m$, 8$\mu m$].

10. The light sensor according to claim 1, wherein the light sensor comprises a plurality of light gathering units arranged in an array.

11. The light sensor according to claim 10, wherein an arrangement period of the light gathering unit is in a range of [4 $\mu m$, 40 $\mu m$], and an aperture size of the light gathering unit is in a range of [4 $\mu m$, 40 $\mu m$], wherein the arrangement period of the light gathering unit is greater than or equal to the aperture size of the light gathering unit.

12. The light sensor according to claim 3, wherein, in the direction perpendicular to the light sensing plane, a distance between the light gathering unit and a bottom surface of the light blocking unit corresponding to the light gathering unit is in a range of [5 $\mu m$, 30 $\mu m$], wherein the bottom surface of the light blocking unit is opposite to the light sensing plane.

13. The light sensor according to any one of claims 1-12, wherein the light blocking unit comprises a light reflecting layer or a light absorbing layer.

14. The light sensor according to any one of claims 1-12, wherein the light gathering unit comprises a lens.

15. An electronic device, comprising: the light sensor according to any one of claims 1-14.

**FIG. 1**

**FIG. 2**

**FIG. 3**

**FIG. 4**

**FIG. 5**

**FIG. 6**

**FIG. 7**

**FIG. 8**

**FIG. 9**

**FIG. 10**

**FIG. 11**

**FIG. 12**

**FIG. 13**

**FIG. 14**

**(a)**

**(b)**

**FIG. 15**